# EUROPÄISCHE PATENTSCHRIFT

(11) **EP 1 883 286 B1**
(45) Veröffentlichungstag und Bekanntmachung des Hinweises auf die Patenterteilung: **02.12.2009**
(21) Anmeldenummer: 07012613.1
(22) Anmeldetag: 27.06.2007
(51) Int. Cl.: H05K 7/14

(54) **Server-Rack mit Einschubvorrichtung**
Server rack with slide-in module
Rack de serveur doté d'un dispositif d'insertion

(30) Priorität: 27.07.2006 DE 102006034845
(43) Veröffentlichungstag der Anmeldung: 30.01.2008
(73) Patentinhaber: Fujitsu Siemens Computers GmbH, 80807 München (DE)
(72) Erfinder: Blume, Johannes, 33034 Brakel (DE); Hesse, Ronny, 33175 Bad Lippspringe (DE)
(74) Vertreter: Epping - Hermann - Fischer

(56) Entgegenhaltungen:
- DE-A1- 19 913 568
- DE-U1- 20 105 293
- US-A1- 2002 043 914

## Beschreibung

Die Erfindung betrifft ein Server-Rack mit einer Einschubvorrichtung.

In einem Server-Rack werden elektrische Geräte, Computer oder Server übereinander angeordnet. Die Geräte werden dazu am Server-Rack befestigt. Zur Befestigung wird oft ein Adapter benutzt, in den das Gerät eingeschoben wird, wobei der Adapter am Server-Rack befestigt ist. Ein Gerät kann auch mit Teleskopschienen am Server-Rack befestigt werden. Dafür werden die Teleskopschienen zum einen am Server-Rack und zum anderen an dem Gerät befestigt. Eine weitere Möglichkeit, Geräte in einem Server-Rack zu befestigen, besteht darin die Geräte am Server-Rack zu verschrauben.

Für eine Befestigung der Geräte mit Schrauben in dafür vorgesehene Montagelöcher an der Vorderseite des Server-Racks werden Schrauben in eine Frontblende des Geräts und in die Montagelöcher eingeschraubt. Die Montagelöcher sind übereinander angeordnet und befinden sich auf der linken und rechten Vorderseite des Server-Racks. Die Vorderseiten von Teleskopschienen werden auch oft über die Montagelöcher mit Schrauben befestigt.

Sollen Geräte verschiedener oder annähernd gleicher Höhe in einem Server-Rack befestigt werden, ist es oft erforderlich, die Geräte in der Höhe zu versetzen, so dass zwischen den Geräten ein Spalt entsteht. Zum einen liegt diese Höhenversetzung an der Lage der Montagelöcher im Server-Rack und zum anderen sollen Geräte, die im Server-Rack befestigt sind, durch den Einbau eines neuen Geräts nicht zerkratzt oder beschädigt werden. Die Veröffentlichungen DE 199 13 568 und US 2002/043914 offenbaren Ernschubvorrichtungen, die höhenverstellbar sind.

Nach dem Einbau in einem Server-Rack werden die Geräte auf ihre Lage im Server-Rack hin untersucht. Wird dabei festgestellt, dass ein Istwert nicht mit dem Sollwert der Lage im Server-Rack übereinstimmt, wird eine entsprechende Änderung am Server vorgenommen. Beispielsweise könnte eine am Gerät befestigte Teleskopschiene in einer veränderten Position erneut am Gerät befestigt werden. Eine solche Veränderung der Position des Geräts im Server-Rack ist mit einem erheblichen Aufwand verbunden.

Der Erfindung liegt daher die Aufgabe zugrunde ein Server-Rack anzugeben, so dass Computer, Server oder andere Systeme, die im Server-Rack angeordnet werden, einfach und exakt im Server-Rack positioniert werden können.

Die Aufgabe wird erfindungsgemäß durch ein Server-Rack mit einer Einschubvorrichtung wie im Anspruch 1 gelöst.

Durch das Verwenden eines erfindungsgemäßen Server-Racks werden Einschubgeräte, die im Server-Rack mit einer erfindungsgemäßen Einschubvorrichtung befestigt sind, von der Vorderseite des Server-Racks aus in der Höhe verstellt. Eingeschobene Geräte müssen nicht aus dem Server-Rack entfernt werden und ein Sollwert der Lage im Server-Rack ist von der Vorderseite aus einfach einzustellen.

Erfindungsgemäß weist die Einschubvorrichtung eine Trägervorrichtung auf, die am Server-Rack fest befestigbar ist. Über Stifte ist eine Führungsschiene beweglich an der Trägervorrichtung befestigbar. In der Führungsschiene ist eine Halteschiene beweglich gelagert und die Halteschiene ist an dem Einschubgerät fest befestigt. Durch die Führungs- und Halteschiene ist ein Auszug gebildet.

Erfindungsgemäß weist die Trägervorrichtung oder Führungsschiene eine von einer Vorderseite des Server-Racks aus zugängliche höhenverstellenbare Einstellvorrichtung auf. Die Einstellvorrichtung ist an der Trägervorrichtung oder Führungsschiene beweglich befestigt und derartig mit der Führungsschiene bzw. Trägervorrichtung verbunden, dass die Führungsschiene über die Einstellvorrichtung gegenüber der Trägervorrichtung höhenverstellbar ist.

Erfindungsgemäß ist die Einstellvorrichtung über ein Bedienungselement von der Vorderseite des Server-Racks aus betätigbar. Durch eine horizontale Verschiebung des Bedienungselements wird eine Höhenverstellung der Führungsschiene hervorgerufen.

Vorteilhafterweise wird die Höhenverstellung von einer Umsetzvorrichtung der Einstellvorrichtung umgesetzt. Es ist vorteilhaft die Umsetzvorrichtung über einen Stift mit der Führungsschiene zu verbinden. Der Stift ist in einem Bereich der Einstellvorrichtung in einer Ausnehmung der Trägervorrichtung führbar.

Vorteilhafterweise ist das Bedienungselement in eine aus der Trägervorrichtung rausgebogene Lasche, die ein Gewinde aufweist, einschraubbar. Das Bedienungselement ist günstigerweise derartig ausgestaltet, dass die Umsetzvorrichtung bei einer Hinein- oder Herausbewegung des Bedienungselements mitbewegt wird.

In einer bevorzugten Ausführungsform weist die Einstellvorrichtung eine Führungsvorrichtung auf, die einerseits an der Trägervorrichtung fest befestigbar ist und andererseits die Bewegung der Umsetzvorrichtung in eine bevorzugte Richtung führt.

In einer bevorzugten Weiterbildung ist die Umsetzvorrichtung keilförmig ausgebildet und ist dazu eingerichtet, auf einem Führungskeil in einer Führungsleiste der Führungsvorrichtung wie auf einer schiefen Ebene zu gleiten. Zum seitlichen Führen der Umsetzvorrichtung weist die Führungsleiste eine Nase auf.

In einer bevorzugten Weiterbildung weist die Umsetzvorrichtung eine schräge Fläche auf, die auf einer schrägen Fläche der Führungsvorrichtung gleitet. In einer weiteren vorteilhaften Ausführungsform ist die Umsetzvorrichtung hebelförmig ausgestaltet.

Weitere mögliche Ausführungsformen, weitere Einzelheiten und Ausgestaltungen der Erfindung sind in den Unteransprüchen gegeben.

Die Erfindung wird nachfolgend an Ausführungsbeispielen anhand der Zeichnungen näher erläutert.

In den Zeichnungen zeigen:
- Figur 1: eine in einem Server-Rack befestigte Einschubvorrichtung,
- Figur 2: eine Draufsicht auf eine Rückseite einer Einschubvorrichtung,
- Figur 3: eine perspektivische Darstellung der Einschubvorrichtung mit ausgezogener Halteschiene,
- Figur 4: eine perspektivische Darstellung einer Trägervorrichtung,
- Figur 5: eine perspektivische Darstellung einer Umsetzvorrichtung,
- Figur 6: eine perspektivische Darstellung eines Befestigungsmittels,
- Figur 7A: eine perspektivische Darstellung eines Führungskeils,
- Figur 7B: eine perspektivische Darstellung einer Führungsleiste,
- Figur 8: eine keilförmige Umsetzvorrichtung,
- Figur 9: eine hebelartige Umsetzvorrichtung, und
- Figur 10: eine perspektivische Darstellung einer Trägervorrichtung mit einer Schienenzwangsführung.

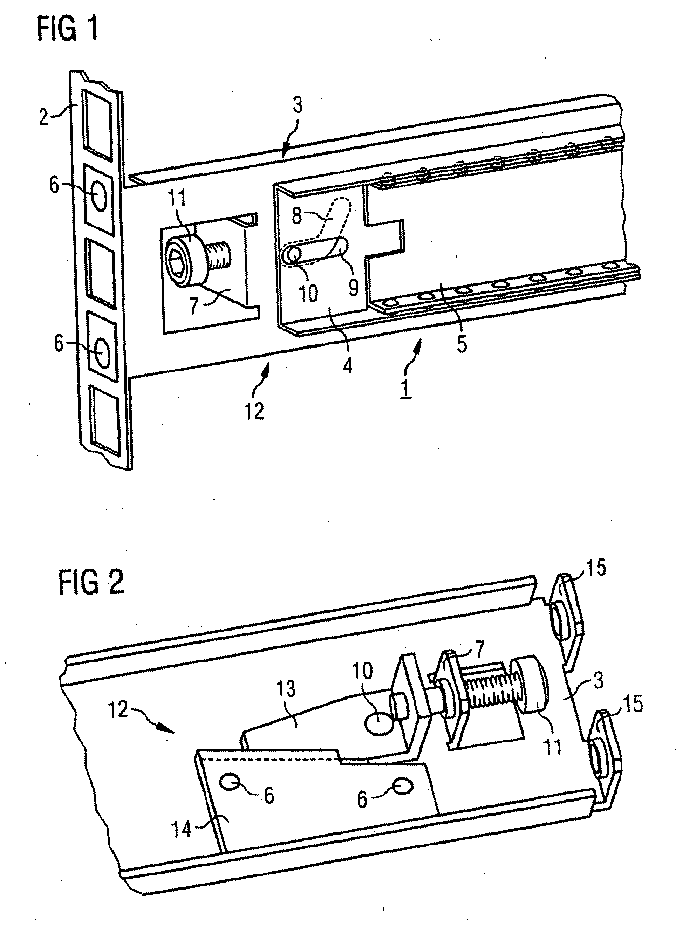

Figur 1 zeigt eine Einschubvorrichtung 1, die in einem Server-Rack 2 montiert ist. Die Einschubvorrichtung 1 weist eine Trägervorrichtung 3, eine Führungsschiene 4 und eine Halteschiene 5 auf. Die Trägervorrichtung 3 ist über Befestigungsmittel 6 am Server-Rack 2 befestigt. Die Führungsschiene 4 ist an der Trägervorrichtung 3 über einen Stift 10 beweglich gelagert. Die Trägervorrichtung 3 weist eine Ausnehmung 8 und die Führungsschiene 4 weist ein Langloch 9 auf. Durch die Ausnehmung 8 und das Langloch 9 erstreckt sich der Stift 10, so dass eine Kulissenführung gebildet wird.

Die Halteschiene 5 ist in der Führungsschiene 4 beweglich gelagert. In diesem Ausführungsbeispiel ist die bewegliche Lagerung der Halteschiene 5 in der Führungsschiene 4 über einen so genannten Kugelkäfig realisiert, der in der Zeichnung mit dort eingezeichneten Rollen angedeutet ist. Die Halteschiene 5 wird fest an einem Einschubgerät befestigt. Das Einschubgerät ist in Figur 1 nicht dargestellt.

Die Trägervorrichtung 3 weist eine Lasche 7 auf, in die ein Bedienungselement 11 eingeschraubt ist. Das Bedienungselement 11 wirkt auf den Stift 10, so dass durch eine horizontale Verschiebung des Betätigungselementes 11 der Stift 10 in dem Langloch 9 verschoben wird. Da sich der Stift 10 auch durch die Ausnehmung 8 erstreckt, bewirkt eine horizontale Verschiebung des Betätigungselementes 11 eine vertikale Verschiebung der Führungsschiene 4 gegenüber der Trägervorrichtung 3. Das Bedienungselement 11 bildet so zusammen mit dem Langloch 9 und der Ausnehmung 8 eine Einstellvorrichtung 12.

Das Bedienungselement 11 ist von einer Vorderseite des Server-Racks 2 aus zugänglich. Eine horizontale Verschiebung des Bedienungselements 11 führt über die Einstellvorrichtung (in der Figur nicht sichtbar) zu einer Verschiebung der Führungsschiene 4 und damit auch die Halteschiene 5 in der Höhe nach oben oder nach unten.

Die Halteschiene 5 ist am Einschubgerät befestigt. Das Einschubgerät wird somit durch das Betätigen des Bedienungselements 11 von der Vorderseite des Server-Racks 2 aus höhenverstellt. Das Einschubgerät bleibt während der Höhenverstellung im Server-Rack 2 und muss nicht herausgenommen oder im Server-Rack 2 entlang einer Teleskopschiene verschoben werden.

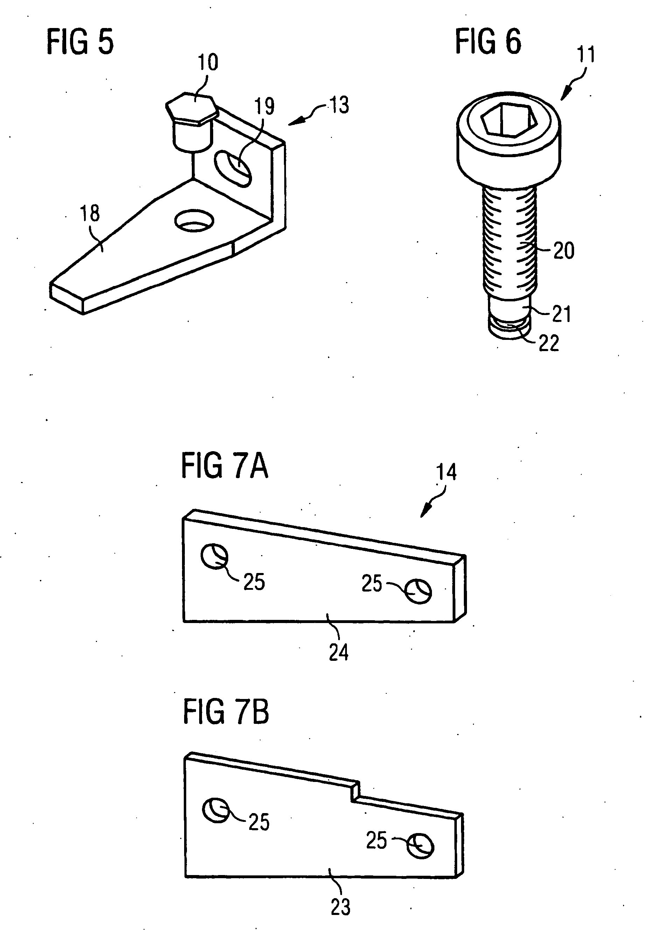

In diesem Ausführungsbeispiel wird das Bedienungselement 11, beispielsweise eine Schraube, deren weitere Ausgestaltung in Figur 6 beschrieben ist, in eine Einpressmutter der Lasche 7 eingeschraubt. Es ist auch möglich das Bedienungselement 11 in ein Gewinde der Lasche 7 einzuschrauben.

Die in dieser Figur dargestellte Einschubvorrichtung 1 wird auf der linken Seite des Server-Racks 2 befestigt. Um ein Einschubgerät in dem Server-Rack 2 zu befestigen, wird auf der rechten Seite des Server-Racks eine zur linken gespiegelte höhenverstellbare Einschubvorrichtung 1 in der gleichen Höhe im Server-Rack 2 befestigt.

Figur 2 zeigt eine Draufsicht auf die Rückseite einer Einschubvorrichtung 1 gemäß einem weiteren Ausführungsbeispiel.

Eine Trägervorrichtung 3 wird über Haltevorrichtungen 15 an einem Server-Rack 2 befestigt. In der Trägervorrichtung 3 ist eine Einstellvorrichtung 12 montiert und weist eine Umsetzvorrichtung in Form eines Keils 13 und eine Führungsvorrichtung 14 auf. Der Keil 13 ist über einen Stift 10 an einer Führungsschiene beweglich befestigt. Der Stift 10 ist in diesem Ausführungsbeispiel fest an dem Keil 13 befestigt und verändert seine Position gegenüber dem Keil 13 nicht. Der Stift 10 ist beweglich an der Führungsschiene befestigt.

Der Keil 13 weist einen gegenüber der Längserstreckung des Keils 13 abgewinkelten Abschnitt auf. Der Keil 13 wird über das Bedienungselement 11, welches auf den abgewinkelten Abschnitt des Keils 13 wirkt, betätigt. Die Funktionsweise des Keils 13 wird in Figur 5 näher erläutert.

Die Führungsvorrichtung 14 besteht in diesem Ausführungsbeispiel aus einer Führungsleiste, die einen Führungskeil aufweist und mit Befestigungsmitteln 6 fest an der Trägervorrichtung 3 befestigt ist. Die Führungsvorrichtung 14 wird in Figur 7A,B näher erläutert.

Wird das Bedienungselement 11 in die Lasche 7 eingeschraubt, verschiebt sich das Bedienungselement 11 in horizontaler Richtung parallel zur Trägervorrichtung 3. Die horizontale Bewegung des Bedienungselements 11 führt zu einer Verschiebung des Keils 13. Der Keil 13 gleitet bei einer Verschiebung auf einem hier nicht sichtbaren Führungskeil wie auf einer schiefen Ebene.

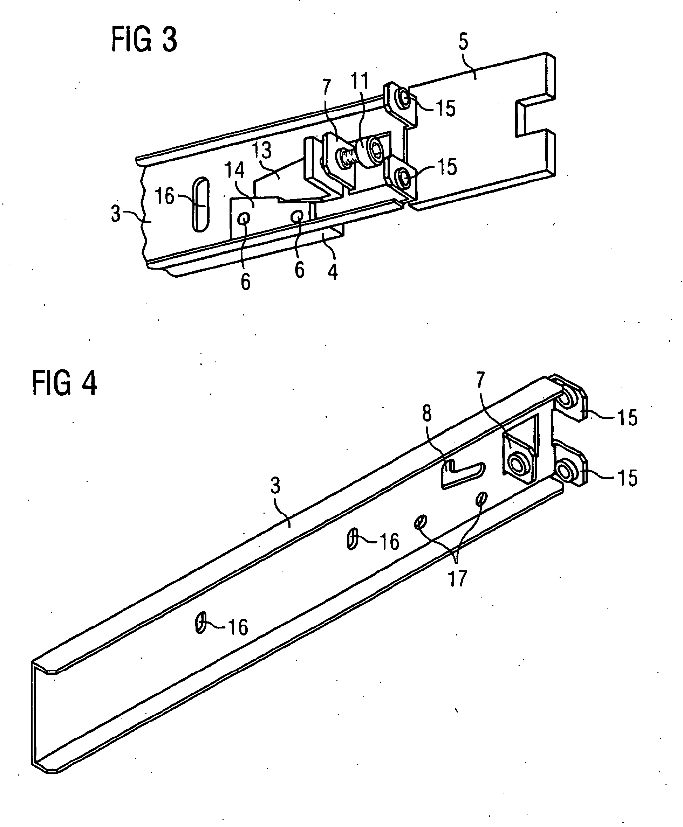

Zusätzlich zu der in Figur 2 beschriebenen Ausführungsform ist in Figur 3 die ausgezogene Halteschiene 5 gezeigt und eines von zwei Langlöchern 16 der Trägervorrichtung 3.

Die Halteschiene 5 ist aus der Führungsschiene 4 herausziehbar und wird fest am Einschubgerät befestigt.

Das Langloch 16 ermöglicht mit einem anderen, hier nicht dargestellten Langloch 16 der Trägervorrichtung 3 eine Höhenverstellung der Führungsschiene 4 in deren hinterem Bereich. Im hinteren Bereich der Führungsschiene 4 sind Stifte, in der Zeichnung nicht dargestellt, fest an der Führungsschiene 4 befestigt. Diese Stifte bewegen sich bei einer Höhenverstellung der Führungsschiene 4 geführt durch das Langloch 16 nach oben oder nach unten. Die Halteschiene 5 wird durch die Führungsschiene 4 mitverstellt und damit auch das Einschubgerät in der Höhe verstellt.

Figur 4 zeigt eine perspektivische Ansicht der Trägervorrichtung 3.

Die Trägervorrichtung 3 hat einen U-förmigen Querschnitt. Im vorderen Bereich weist die Trägervorrichtung 3 die Haltevorrichtungen 15 auf. In diesem Ausführungsbeispiel wird in die Haltevorrichtungen 15 jeweils eine Einpressmutter befestigt.

In einem Bereich hinter den Haltevorrichtungen 15 ist die Lasche 7 aus der Trägervorrichtung 3 rausgebogen. In der Lasche 7 ist in diesem Ausführungsbeispiel eine Einpressmutter befestigt.

In einem Bereich hinter der Lasche 7 ist die Ausnehmung 8 und unterhalb der Ausnehmung 8 zwei Bohrungen 17 angeordnet. Über die Bohrungen 17 ist die Führungsvorrichtung 14 mit Befestigungsmitteln 6 an der Trägervorrichtung 3 befestigt. Mit der Ausnehmung 8 wird der Stift 10 geführt.

Im hinteren Bereich der Trägervorrichtung 3 sind zwei Langlöcher 16 angeordnet. In diesen Langlöchern 16 wird die Führungsschiene 4 über die fest an der Führungsschiene 4 befestigten Stifte 10 geführt, da sich im montierten Zustand der Einschubvorrichtung 1 die Stifte 10 durch die Langlöcher 16 der Trägervorrichtung 3 erstrecken.

Figur 5 zeigt eine perspektivische Darstellung der Umsetzvorrichtung in Form eines Keils 13. Der Keil 13 ist aus einem keilförmigen Teil 18 und aus einer dazu senkrecht stehenden rechteckförmigen Fläche gebildet. Der keilförmige Teil 18 weist in einem Bereich nahe der senkrechten Fläche eine Bohrung auf. In diese Bohrung wird der Stift 10 eingesteckt oder eingeschraubt. Der Stift 10 ist fest mit dem keilförmigen Teil 18 des Keils 13 verbunden.

Die rechteckförmige Fläche des Keils 13 weist ein Langloch 19 auf. Das Langloch 19 ist derartig ausgebildet, dass sich das Bedienungselement 11 darin bewegen kann. Die Länge des Langlochs entspricht vorzugsweise der maximalen Höhenverstellung der Einstellvorrichtung 12 beziehungsweise des Keils 13.

Figur 6 zeigt eine perspektivische Darstellung des Bedienungselements 11.

In diesem Ausführungsbeispiel ist das Bedienungselement 11 eine Schraube. Das Bedienungselement 11 hat einen runden Schraubenkopf, einen vorderen Teil 20 mit einem Gewinde und einen hinteren Teil 21 ohne Gewinde und mit einem kleineren Durchmesser als der vordere Teil 20. Der hintere Teil 21 weist eine Einkerbung 22 auf.

Der vordere Teil 20 des Bedienungselements 11 wird in die Einpressmutter der Lasche 7 eingeschraubt. Der hintere Teil 21 des Bedienungselements 11 befindet sich in dem Langloch 19 der Umsetzvorrichtung 13. In der Einkerbung 22 des Bedienungselements 11 wird auf der rückwärtigen Seite der senkrechten Fläche des Keils 13 ein Haltering befestigt. Der Haltering sichert das Mitführen des Keils 13 bei einem Herausdrehen des Bedienungselements 11 aus der Lasche 7. Durch ein Herausdrehen des Bedienungselements 11 wird die Führungsschiene 11 in der Höhe nach unten verstellt.

Figur 7 zeigt die Führungsvorrichtung 14 bestehend aus der Führungsleiste 23 und dem Führungskeil 24.

Die Führungsleiste 23 sowie der Führungskeil 24 weisen jeweils zwei Bohrungen 25 auf. Mit Befestigungsmitteln 6, die in diese Bohrungen 25 eingeschraubt werden, ist die Führungsleiste 23 fest am Führungskeil 24 und an der Trägervorrichtung 3 befestigt ist. Die Befestigungsmittel 6 werden in die Bohrungen 17 der Trägervorrichtung 3 eingeschraubt.

Die Führungsleiste 23 weist im mittleren Bereich eine Nase auf, die eine seitliche Verschiebung der Umsetzvorrichtung 13 verhindert. Die Umsetzvorrichtung 13 wird über die Nase der Führungsleiste 23 seitlich geführt. Das heißt, die Umsetzvorrichtung 13 kann sich nur in eine Richtung, nämlich parallel zur Trägervorrichtung 3 bewegen. Eine Bewegungsrichtung quer zur Trägervorrichtung 3 wird durch die Nase der Führungsleiste 23 verhindert.

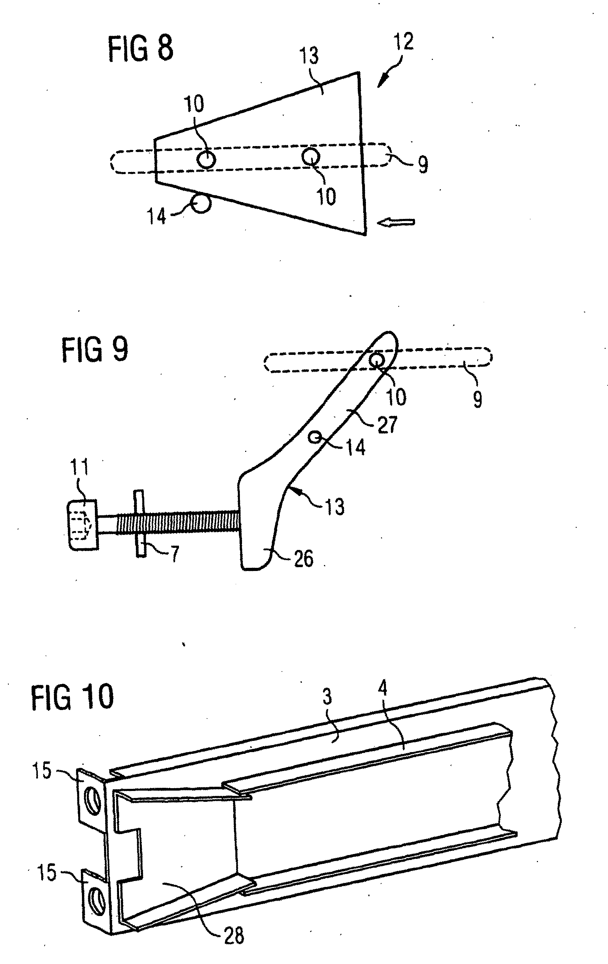

Figur 8 zeigt ein weiteres Ausführungsbeispiel einer Einstellvorrichtung 12.

Eine Umsetzvorrichtung 13 ist keilförmig ausgebildet. Eine Führungsvorrichtung 14 ist zylinderförmig, in Form eines Stabes, ausgebildet und wird fest an der Trägervorrichtung 3 befestigt.

Die Umsetzvorrichtung 13 wird über ein nicht dargestelltes Bedienungselement 11 betätigt. Es wird hier lediglich die Bewegungsrichtung des Bedienungselements 11 mit einem Pfeil angedeutet. Zwei Stifte 10 sind fest an der Umsetzvorrichtung 13 befestigt und bewegen sich in einem Langloch 9 der Führungsschiene 4. Die Stifte 10 sind beweglich mit der Führungsschiene 4 gekoppelt.

Wird die Umsetzvorrichtung 13 in Pfeilrichtung verschoben gleitet die Umsetzvorrichtung 13 auf der Führungsvorrichtung 14. Durch eine horizontale Verschiebung der Umsetzvorrichtung 13 wird gleichzeitig die Umsetzvorrichtung 13 durch die Führungsvorrichtung 14 zu einer vertikalen Verschiebung, also einer Höhenverstellung gezwungen. Die Stifte 10 verschieben sich dabei horizontal im Langloch 9 der Führungsschiene 4.

Die Höhenverstellung der Umsetzvorrichtung 13 führt zu einer Höhenverstellung der Führungsschiene 4, der Halteschiene 5 und damit des Einschubgeräts.

In der Trägervorrichtung 3 müssen für jeweils einen der Stifte 10 Ausnehmungen 8 wie in Figur 4 vorhanden sein, damit die Umsetzvorrichtung 13 in Bezug zur Trägervorrichtung 3 die kombinierte Bewegung einer horizontalen und vertikalen Verschiebung ausführen kann.

Figur 9 zeigt ein weiteres Ausführungsbeispiel einer Umsetzvorrichtung 13.

Die Umsetzvorrichtung 13 hat eine hebelförmige Ausgestaltung und wird von einem Bedienungselement 11 betätigt. Das Bedienungselement wird in eine Lasche 7 eingeschraubt. Die Umsetzvorrichtung 13 ist drehbar um die Führungsvorrichtung 14 gelagert. Die Führungsvorrichtung 14 ist fest an der Trägervorrichtung 3 befestigt. Ein Stift 10 ist fest an der Umsetzvorrichtung 13 befestigt und bewegt sich in einem Langloch 9 der Führungsschiene 4. Der Stift 10 ist beweglich an der Führungsschiene 4 befestigt.

Durch eine horizontale Verschiebung des Bedienungselements 11 wird ein vorderer Teil 26 der Umsetzvorrichtung 13 in Bewegungsrichtung des Stiftes 10 verschoben. Durch die hebelförmige Ausgestaltung der Umsetzvorrichtung 13 wird der obere Teil 27 der Umsetzvorrichtung 13 in eine vertikale Bewegung (Höhenverstellung) gezwungen, wobei sich der Stift 10 im Langloch 9 horizontal und gegen die Bewegungsrichtung des Bedienungselements 11 bewegt. Der Stift 10 wird in einer Ausnehmung 8 der Trägervorrichtung 3 wie in Figur 4 geführt.

Die Höhenverstellung des oberen Teils 27 der Umsetzvorrichtung 13 führt zu einer Höhenverstellung der Führungsschiene 4 und damit zu einer Höhenverstellung eines Einschubgeräts das sich in einem Server-Rack in einer Halteschiene einer Einschubvorrichtung befindet.

Figur 10 zeigt in einem weiteren Ausführungsbeispiel eine Trägervorrichtung 3 mit einer Schienenzwangsführung 28.

Die Schienenzwangsführung 28 schließt bündig mit einer Vorderseite einer Führungsschiene 4 ab. Die Schienenzwangsführung 28 wird an der Führungsschiene 4 befestigt, um ein Einfädeln eines Einschubsgeräts in eine Halteschiene, die in der Führungsschiene 4 beweglich gelagert ist, zu erleichtern. Für eine bessere Darstellung ist die Halteschiene in der Zeichnung nicht dargestellt.

Durch eine Einschubvorrichtung, wie in diesem Ausführungsbeispiel, wird das Einschubgerät in die Schienenzwangsführung 28 auf einer beliebigen Höhe der Schienenzwangsführung 28 eingeschoben. Durch die Ausgestaltung der Schienenzwangsführung 28 wird das Einschubgerät in die Halteschiene der Führungsschiene eingefädelt und ist dann fest an der Halteschiene befestigt. Die in der Zeichnung nicht sichtbare Einstellvorrichtung über die das Einschubgerät von der Vorderseite eines Server-Racks aus höhenverstellbar ist, gewährleistet eine genaue Positionierung des Einschubgerätes in einem Server-Rack.

Weitere Ausführungsbeispiele der Erfindung werden hier nicht weiter erläutert, sind aber von der Erfindung umfasst.

### Bezugszeichenliste

- 1: Einschubvorrichtung
- 2: Server-Rack
- 3: Trägervorrichtung
- 4: Führungsschiene
- 5: Halteschiene
- 6: Befestigungsmittel
- 7: Lasche
- 8: Ausnehmung
- 9: Langloch
- 10: Stift
- 11: Bedienungselement
- 12: Einstellvorrichtung
- 13: Umsetzvorrichtung
- 14: Führungsvorrichtung
- 15: Haltevorrichtung
- 16: Langloch
- 17: Bohrung
- 18: keilförmiger Teil
- 19: Langloch
- 20: Schraube vorderer Teil
- 21: Schraube hinterer Teil
- 22: Einkerbung
- 23: Führungsleiste
- 24: Führungskeil
- 25: Bohrung
- 26: vordere Teil Umsetzvorrichtung
- 27: obere Teil Umsetzvorrichtung
- 28: Schienenzwangsführung

## Patentansprüche

1. Server-Rack (2) mit einer Einschubvorrichtung (1), die eine Trägervorrichtung (3), die über Befestigungsmittel (6) am Server-Rack (2) befestigbar ist, eine Führungsschiene (4') die beweglich an der Trägervorrichtung (3) befestigbar ist, und eine Halteschiene (5), die in der Führungsschiene (4) beweglich gelagert und an einem Einschubgerät befestigbar ist aufweist und dazu eingerichtet ist, von einer Vorderseite des Server-Racks (2) aus über eine Einstellvorrichtung (12) mit einem Bedienungselement (11) höhenverstellbar zu sein, wobei die Einstellvorrichtung (12) eine Umsetzvorrichtung (13) aufweist, die ein Betätigen des Bedienungselements (11) in eine Höhenverstellung der Führungsschiene (4) umsetzt.

2. Server-Rack (2) nach Anspruch 1,
**dadurch gekennzeichnet, dass**
- die Einstellvorrichtung (12) an der Trägervorrichtung (3) befestigt ist, und
- die Führungsschiene (4) über die Einstellvorrichtung (12) gegenüber der Trägervorrichtung (3) höhenverstellbar ist.

3. Server-Rack (2) nach Anspruch 1 oder 2,
**dadurch gekennzeichnet, dass**
- die Umsetzvorrichtung (13) über einen Stift (10) mit der Führungsschiene (4) verbunden ist und der Stift (10) im Bereich der Einstellvorrichtung (12) in einer Ausnehmung (8) der Trägervorrichtung (3) führbar ist, und
- eine Führungsvorrichtung (14) über Befestigungsmittel (6) an der Trägervorrichtung (3) befestigbar ist.

4. Server-Rack (2) nach Anspruch 3,
**dadurch gekennzeichnet, dass**
die Umsetzvorrichtung (13) eine schräge Fläche aufweist, die auf einer schrägen Fläche der Führungsvorrichtung (14) gleitet.

5. Server-Rack (2) nach Anspruch 3 oder 4,
**dadurch gekennzeichnet, dass**
- die Umsetzvorrichtung (13) keilförmig ausgebildet und dazu eingerichtet ist auf einem Führungskeil (24) in einer Führungsleiste (23) der Führungsvorrichtung (14) wie auf einer schiefen Ebene in der Führungsleiste (23) zu gleiten, und
- die Führungsleiste (23) eine Nase zum seitlichen Führen der Umsetzvorrichtung (13) aufweist.

6. Server-Rack (2) nach Anspruch 3 oder 4,
**dadurch gekennzeichnet, dass**
die Umsetzvorrichtung (13) keilförmig ausgebildet ist und auf einem Halteelement der Führungsvorrichtung (14) gleitet.

7. Server-Rack (2) nach Anspruch 3,
**dadurch gekennzeichnet, dass**
die Umsetzvorrichtung (13) eine hebelförmige Ausgestaltung aufweist.

8. Server-Rack (2) nach Anspruch 1,
**dadurch gekennzeichnet, dass**
das Bedienungselement (11) in eine aus der Trägervorrichtung (3) heraus gebogene, mit einem Gewinde versehene Lasche (7) einschraubbar ist.

9. Server-Rack (2) nach Anspruch 8,
**dadurch gekennzeichnet, dass**
das Bedienungselement (11) eine Schraube ist und die Umsetzvorrichtung (13) mit einer Feder an der Lasche (7) befestigt ist.

10. Server-Rack (2) nach einem der Ansprüche 1 bis 9,
**dadurch gekennzeichnet, dass**
die Trägervorrichtung (3) über Haltevorrichtungen (15) an einem vorderen Ende der Trägervorrichtung (3) an dem Server-Rack (2) befestigbar ist.

11. Server-Rack (2) nach einem der Ansprüche 1 bis 10,
**dadurch gekennzeichnet, dass**
- an der Führungsschiene (4) auf einer der Trägervorrichtung (3) zugewandten Seite, Stifte (10) fest an der Führungsschiene (4) befestigbar sind, und
- die Führungsschiene (4) über die Stifte (10) und über Langlöcher (16) der Trägervorrichtung (3) beweglich an der Trägervorrichtung (3) befestigbar ist.

12. Server-Rack (2) nach einem der Ansprüche 8 bis 11,
**dadurch gekennzeichnet, dass**
die Führungsschiene (4) bündig mit der Lasche (7) der Trägervorrichtung (3) abschließt.

13. Server-Rack (2) nach einem der Ansprüche 1 bis 12,
**dadurch gekennzeichnet, dass**
eine Schienenzwangführung (28) an einer vorderen Seite der Führungsschiene (4) befestigbar ist.

14. Server-Rack (2) nach einem der Ansprüche 1 bis 13,
**dadurch gekennzeichnet, dass**
das Server-Rack (2) jeweils eine linke und eine rechte höhenverstellbare Einschubvorrichtung (1) zur Aufnahme eines Einschubgeräts in das Server-Rack (2) aufweist.

## Claims

1. Server rack (2) having an insert apparatus (1) which has a support apparatus (3) which can be fixed to the server rack (2) by means of fixing means (6), a guide rail (4) which can be fixed, in a moveable manner, to the support apparatus (3) and a mounting rail (5) which is moveably mounted in the guide rail (4) and can be fixed to an insert device, the insert apparatus (1) being designed to be vertically adjustable from a front face of the server rack (2) by means of an adjustment apparatus (12) with an operator control element (11), the adjustment apparatus (12) having a conversion apparatus (13) which converts operation of the operator control element (11) into a vertical adjustment of the guide rail (4).

2. Server rack (2) according to Claim 1,
**characterized in that**
- the adjustment apparatus (12) is fixed to the support apparatus (3), and
- the guide rail (4) can be vertically adjusted in relation to the support apparatus (3) by means of the adjustment apparatus (12).

3. Server rack (2) according to Claim 1 or 2,
**characterized in that**
- the conversion apparatus (13) is connected to the guide rail (4) by means of a pin (10) and the pin (10) can be guided in the region of the adjustment apparatus (12) in a recess (8) in the support apparatus (3), and
- a guide apparatus (14) can be fixed to the support apparatus (3) by means of fixing means (6).

4. Server rack (2) according to Claim 3,
**characterized in that**
the conversion apparatus (13) has an oblique face which slides on an oblique face of the guide apparatus (14).

5. Server rack (2) according to Claim 3 or 4,
**characterized in that**
- the conversion apparatus (13) is wedge-like and is designed to slide on a guide wedge (24) in a guide strip (23) of the guide apparatus (14) as on a slanting plane in the guide strip (23), and
- the guide strip (23) has a projection for laterally guiding the conversion apparatus (13).

6. Server rack (2) according to Claim 3 or 4,
**characterized in that**
the conversion apparatus (13) is wedge-like and slides on a retaining element of the guide apparatus (14).

7. Server rack (2) according to Claim 3,
**characterized in that**
the conversion apparatus (13) has a lever-like design.

8. Server rack (2) according to Claim 1,
**characterized in that**
the operator control element (11) can be screwed into a lug (7) which is bent out of the support apparatus (3) and is provided with a thread.

9. Server rack (2) according to Claim 8,
**characterized in that**
the operator control element (11) is a screw and the conversion apparatus (13) is fixed to the lug (7) by way of a spring.

10. Server rack (2) according to one of Claims 1 to 9,
**characterized in that**
the support apparatus (3) can be fixed to the server rack (2) at a front end of the support apparatus (3) by means of retaining apparatuses (15).

11. Server rack (2) according to one of Claims 1 to 10,
**characterized in that**
- on the guide rail (4), pins (10) can be firmly fixed to the guide rail (4) on a side which faces the support apparatus (3), and
- the guide rail (4) can be movably fixed to the support apparatus (3) by means of the pins (10) and by means of holes (16) in the support apparatus (3).

12. Server rack (2) according to one of Claims 8 to 11,
**characterized in that**
the guide rail (4) terminates flush with the lug (7) of the support apparatus (3).

13. Server rack (2) according to one of Claims 1 to 12,
**characterized in that**
a positive rail guide (28) can be fixed to a front face of the guide rail (4).

14. Server rack (2) according to one of Claims 1 to 13,
**characterized in that**
the server rack (2) in each case has a left-hand and a right-hand vertically adjustable insert apparatus (1) for holding an insert device in the server rack (2).

## Revendications

1. Rack de serveur (2) doté d'un dispositif d'insertion (1), qui présente :
- un dispositif de support (3) qui peut être fixé par le biais de moyens de fixation (6) au rack de serveur (2), un rail de guidage (4) qui peut être fixé de manière mobile sur le dispositif de support (3), et
- un rail de fixation (5) qui est monté de manière mobile dans le rail de guidage (4) et qui peut être fixé sur un appareil d'insertion, le dispositif d'insertion (1) étant prévu pour pouvoir être réglé en hauteur depuis une face avant du rack de serveur (2) par le biais d'un dispositif d'ajustement (12) avec un élément de commande (11), le dispositif d'ajustement (12) présentant un dispositif convertisseur (13) qui convertit un actionnement de l'élément de commande (11) en un réglage en hauteur du rail de guidage (4).

2. Rack de serveur (2) selon la revendication 1,
**caractérisé en ce que**
- le dispositif d'ajustement (12) est fixé au dispositif de support (3), et
- le rail de guidage (4) peut être réglé en hauteur par le biais du dispositif d'ajustement (12) par rapport au dispositif de support (3).

3. Rack de serveur (2) selon la revendication 1 ou 2,
**caractérisé en ce que**
- le dispositif convertisseur (13) est connecté par le biais d'une goupille (10) au rail de guidage (4), et la goupille (10) peut être guidée dans la région du dispositif d'ajustement (12) dans un évidement (8) du dispositif de support (3), et
- un dispositif de guidage (14) peut être fixé par le biais de moyens de fixation (6) au dispositif de support (3).

4. Rack de serveur (2) selon la revendication 3,
**caractérisé en ce que**
le dispositif convertisseur (13) présente une surface oblique qui glisse sur une surface oblique du dispositif de guidage (14).

5. Rack de serveur (2) selon la revendication 3 ou 4,
**caractérisé en ce que**
- le dispositif convertisseur (13) est réalisé en forme de cale et est prévu pour glisser sur une cale de guidage (24) dans une barre de guidage (23) du dispositif de guidage (14) comme sur un plan oblique dans la barre de guidage (23) et
- la barre de guidage (23) présente un nez pour le guidage latéral du dispositif convertisseur (13).

6. Rack de serveur (2) selon la revendication 3 ou 4,
**caractérisé en ce que**
le dispositif convertisseur (13) est réalisé en forme de cale et glisse sur un élément de retenue du dispositif de guidage (14).

7. Rack de serveur (2) selon la revendication 3,
**caractérisé en ce que**
le dispositif convertisseur (13) présente une configuration en forme de levier.

8. Rack de serveur (2) selon la revendication 1, **caractérisé en ce que** l'élément de commande (11) peut être vissé dans une patte (7) pourvue d'un filetage, cintrée hors du dispositif de support (3).

9. Rack de serveur (2) selon la revendication 8,
**caractérisé en ce que**
l'élément de commande (11) est une vis et le dispositif convertisseur (13) est fixé à la patte (7) au moyen d'un ressort.

10. Rack de serveur (2) selon l'une quelconque des revendications 1 à 9,
**caractérisé en ce que**
le dispositif de support (3) peut être fixé sur le rack de serveur (2) par le biais de dispositifs de fixation (15) à une extrémité avant du dispositif de support (3).

11. Rack de serveur (2) selon l'une quelconque des revendications 1 à 10,
**caractérisé en ce que**
- des goupilles (10) peuvent être fixées rigidement sur le rail de guidage (4) sur un côté tourné vers le dispositif de support (3), et
- le rail de guidage (4) peut être fixé de manière mobile au dispositif de support (3) par le biais des goupilles (10) et par le biais de trous oblongs (16) du dispositif de support (3).

12. Rack de serveur (2) selon l'une quelconque des revendications 8 à 11,
**caractérisé en ce que**
le rail de guidage (4) se termine en affleurement avec la patte (7) du dispositif de support (3).

13. Rack de serveur (2) selon l'une quelconque des revendications 1 à 12, **caractérisé en ce qu'**un guidage forcé du rail (28) peut être fixé sur une face avant du rail de guidage (4).

14. Rack de serveur (2) selon l'une quelconque des revendications 1 à 13, **caractérisé en ce que**
le rack de serveur (2) présente à chaque fois un dispositif d'insertion (1) gauche et droit, réglable en hauteur, pour recevoir un appareil d'insertion dans le rack de serveur (2).
